# EUROPEAN PATENT SPECIFICATION

(11) **EP 4 553 778 B1**
(45) Date of publication and mention of the grant of the patent: **10.06.2026**
(21) Application number: 24211538.4
(22) Date of filing: 07.11.2024
(51) Int. Cl.: G06T 17/00, H04N 21/234, H04N 21/4728, H04N 21/81, H04N 21/845, G06F 3/01, H04N 21/00

(54) **ADAPTIVE DYNAMIC LOADING STRATEGY FOR RENDERING LARGE THREE-DIMENSIONAL MODELS**
ADAPTIVE DYNAMISCHE LADESTRATEGIE ZUR DARSTELLUNG GROSSER DREIDIMENSIONALER MODELLE
STRATÉGIE DE CHARGEMENT DYNAMIQUE ADAPTATIF POUR RESTITUER DE GRANDS MODÈLES TRIDIMENSIONNELS

(30) Priority: 10.11.2023 US 202318506971
(43) Date of publication of application: 14.05.2025
(73) Proprietor: Autodesk, Inc., San Francisco, CA 94105 (US)
(72) Inventor: MOREL, Sebastien, San Francisco, 94105 (US); MENON, Ajay Vijayabalan, San Francisco, 94105 (US); CASALLAS SUAREZ, Juan Sebastian, San Francisco, 94105 (US); JATKAR, Hrishikesh Dilip, San Francisco, 94105 (US)
(74) Representative: Fish & Richardson P.C.

(56) References cited:
- RU-C1- 2 736 628
- US-A1- 2017 011 451
- US-B1- 6 684 255

## Description

### BACKGROUND

This specification relates to visualization of three-dimensional models on client devices. Further, this specification relates to model data used in computer graphics applications, such as computer-generated animation and/or computer visualization systems and techniques.

### SUMMARY

This specification relates to adaptive dynamic loading techniques for determining objects from 3D models for loading and rendering that take into consideration the position of the user when viewing the 3D model as well as model load limits for rendering frames of the 3D model by a client device.

In general, one or more aspects of the subject matter described in this specification can be embodied in one or more methods (and also one or more non-transitory computer-readable mediums tangibly encoding a computer program operable to cause data processing apparatus to perform operations), including: obtaining, by a computer having a display device and local memory, a three-dimensional spatial access tree data structure encoding location information for objects in a three-dimensional model of an environment, wherein the three-dimensional model is stored on a remote computer system; ranking, by the computer, a set of the objects in the three-dimensional model to form an object hierarchy based at least on distances between each object of the set of objects and a specified viewpoint for a user within the environment, as determined using the three-dimensional spatial access tree data structure; selecting, by the computer, a proper subset of the set of objects to be rendered based on the object hierarchy and a current model load limit; downloading, by the computer and from the remote computer system, the proper subset of the set of objects to the local memory; and rendering, by the computer, the proper subset of the set of objects from the local memory to the display device based on the specified viewpoint within the environment for the user.

By utilizing the described techniques, the following advantages are achieved. Based on the dynamic adaptable loading techniques implemented for a client application as described in the present disclosure, the rendering of 3D data on a user device can be facilitated and executed more efficiently, with less computational resource requirements for the user device, and without negatively impacting the experience of the user. The loading techniques do not require that the 3D model is loaded as a whole and thus the present solution can work at any scale of the model. The loading techniques are auto-tuned based on how the rendering device performs. Based on the device performance, in some cases more objects can be rendered compared to the other. By determining which objects to be loaded and rendered according to the dynamic loading strategy, flexible yet efficient switching between different display modes and different levels of data to be rendered during movement of the user in the 3D space can be supported. It can be iteratively determined whether and which objects from a 3D model to be download, rather than downloading the model as a whole in the beginning of the rendering, which can significantly decrease the performance and slow down the client application. Further, the preemptive loading and unloading of objects is based on determining a zone of confidence around the viewpoint of the user within a 3D environment of the model and considering the performance of the user device. Such adaptive loading techniques can improve the performance of the client application and support smooth rendering during user navigation within the space. In such way, the rendering is executed faster, and the client application is more responsive to user interactions to navigate within the space. Rendering of different sets of objects while the user changes its viewpoint can be performed faster, since the loading strategy identifies objects to be downloaded on the rendering device that are prioritized based on objects' positions relative to the user's viewpoint and a current model load limit of the user device. The loading strategy allows for keeping a ranked list of objects to be used for determining which objects to download while observing the frames per second generation and the memory consumption on the rendering device.

The described techniques can support stable rendering performance at the user device that improves the user experience and is considerate to the memory capacity and rendering load of the device. The frame generation rate can vary and loading and rendering of objects can be adjusted to match the desired frame generation rate and to improve the performance of the display device without negatively impacting the user experience. Further, the loading strategy can support loading of additional objects that may not be immediately rendered for a particular scene, and unloading of objects according to monitored performance of the user device.

The details of one or more embodiments of the subject matter described in this specification are set forth in the accompanying drawings and the description below. Other features, aspects, and advantages of the invention will become apparent from the description, the drawings, and the claims.

### BRIEF DESCRIPTION OF THE DRAWINGS

FIG. 1 shows an example of a system usable to support visualization of large models in accordance with the implementations of the present disclosure.
FIG. 2 shows an example of a process to navigate within a 3D model of an environment that is rendered according to a dynamic object loading strategy that efficiently utilizes resources at a client device to render the model in accordance with implementations of the present disclosure.
FIGS. 3A and 3B show examples of user interactions for navigating within a spatial view of a virtual reality (VR) environment rendered at a display device by a client device in accordance with implementations of the present disclosure.
FIG. 4 shows an example of a system architecture of a client device used for rendering 3D models based on an adaptive dynamic loading strategy in accordance with implementations of the present disclosure.
FIGS. 5A and 5B show examples of user interactions with a user interface provided by a client application on a user device to navigate within a 3D model of an environment where objects are rendered according to an implemented adaptive dynamic loading strategy in accordance with implementations of the present disclosure.
FIG. 6 is a schematic diagram of a data processing system including a data processing apparatus, which can be programmed as a client or as a server.

Like reference numbers and designations in the various drawings indicate like elements.

### DETAILED DESCRIPTION

The present disclosure describes various tools and techniques for adaptive dynamic loading of objects of a three-dimensional (3D) model that is to be rendered on a client device. The described techniques support stable performance for the rendering (e.g., without crashing of the client device due to overloading from processing large data portions). In accordance with the implementations of the present disclosure, objects can be rendered progressively while a user navigates within a 3D model of an environment and zoom in or zoom out of the model. In some implementations, the rendering can be performed in a virtual reality environment or an augmented reality environment, as well as a combination of those where different users can render and interact with a model through different devices.

In some implementations, the 3D models can be rendered from different devices or platforms, including desktop devices, tablets, virtual reality (VR) and/or augmented reality (AR) devices, among other examples. Computer graphics applications include different software products and/or services that support generation of representations of 3D objects that can be used for visualization of object models, for animation and video rendering, in the context of video games, or other contexts. Computer graphics applications also include computer animation programs showing views or scenes during user reviews and navigation inside or outside of a model.

In some cases, 3D computer visualizations can be created in a variety of scenarios and in the context of different technologies. For example, 3D models of objects such as manufacturing sites, buildings, physical constructions, can be animated for display on user interfaces of native device applications, web applications, VR applications, AR applications, among other examples. The user devices can display user interfaces where objects of 3D models are rendered.

In some implementations, one user may participate in a VR session where a 3D model is requested to be displayed in the context of navigating within the 3D model on a user device such as a VR device or a laptop. The model that is to be render may be a large model that requires a lot of computational resources (such as memory capacity of the rendering device) to load and be rendered in full (or to a larger extent), which may impose some challenges for execution on a small personal user device that does not have the resources needed for the large model loading. For example, models can be very large where even a high-end personal computer with multiple graphical processing units could not manage to load the model without a delay in time. The user devices that can be used to load a model may have limitations to their loading limits. Thus, rendering objects of a large model can be associated with challenges and risks of providing poor user experience or performance (e.g., crashing of the client application used for the rendering).

In accordance with the implementations of the present disclosure, a client application can be configured to enable a loading strategy for objects of the model to be rendered while a user moves within an environment (e.g., a virtual reality environment) that can result in a smooth and flexible workflow that is supported by efficient tools that flexibly adjust the loading strategy and tune it to the memory consumption of loading objects in real time and monitoring a current frame generation rate for rendering.

People can use different user interface applications to navigate in a 3D space in real-time and change the viewpoint for viewing portions of a 3D model. For example, a viewpoint can be initially outside of the model, which can be a model of a building, where based on interaction and repositioning of a user in relation to the model, the viewpoint can be changed and the building can be viewed from a closer distance or from within, e.g., within a particular room or floor of the building. At each step of changing the viewpoint of a user, different objects of the 3D model can be relevant for the rendering. In accordance with the present implementations, objects can be dynamically loaded as a user moves within the environment and the number of objects that are rendered as part of the model can be dynamically adjusted based on monitored metrics of the rendering at the device (e.g., monitoring of the generated frames per second (FPS) and the memory consumption). The metric can be considered when determining the quantity of objects for visualization, where this quantity can be autotuned iteratively while the user moves and changes their viewpoint within the model. Based on monitoring the measured frame rates and memory consumption for the currently rendered scene, a model load limit can be dynamically adjusted to scale the load on the processor to handle downloading and rendering of objects iteratively as the user moves.

In some implementations, a platform can be accessed through VR devices such as a VR headset, a head mounted display, a smart phone display, or other devices, and a VR display can present a VR environment that can be rendered to one or multiple users wearing VR headsets to provide them with an immersive experience to navigate within a 3D model that is rendered in a review mode within the VR environment. In some implementations, a VR environment can be accessed by users via VR, AR, and optionally with non-VR and non-AR devices to provide a display of a 3D model in a virtual world. The rendering capabilities for the display of the model may differ from one device to another and they may be adjusted to the current rendering performance at the particular device.

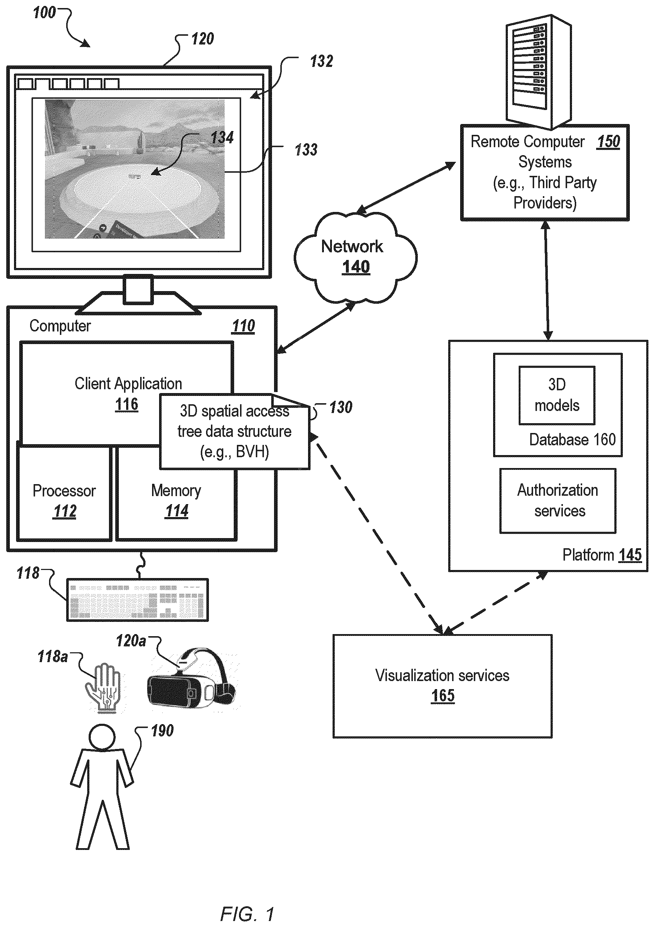

FIG. 1 shows an example of a system 100 usable to support visualization of models without size limitations for the models in an adaptive yet computationally efficient manner by generating a dynamic loading strategy in accordance with implementations of the present disclosure. A computer 110 includes a processor 112 and a memory 114, and the computer 110 can be connected to a network 140, which can be a private network, a public network, a virtual private network, etc. The processor 112 can be one or more hardware processors, which can each include multiple processor cores. The memory 114 can include both volatile and non-volatile memory, such as Random Access Memory (RAM) and Flash RAM. The computer 110 can include various types of computer storage media and devices, which can include the memory 114, to store instructions of programs that run on the processor 112, including VR programs, AR programs, video games, or design interaction applications which support view exploration and collaboration, among other examples.

The computer 110 includes a client application 116 that includes implemented logic to help users involve in rendering and navigating within a 3D model of an environment. For example, the client application 116 can be groupware designed to support the user 190 in a collaboration process with another user that uses another client application, where both users navigate within the 3D model. For example, the client application 116 can be used by the user 190 to intentionally navigate into the 3D model to show various aspects of the model that can be rendered at another client application of another user (e.g., viewed from another viewpoint in the 3D model as specified for the other user). For example, that can be part of a collaborative design process between a design user using the client application 116 to navigate within a construction project and a stakeholder of the construction project that is presented with a view of the model from outside and inside in different level of detail. In some instances, the client application 116 can provide software functionality to facilitate collaborative processes between connected devices for a shared view of the 3D model of the environment. In accordance with the present implementations, loading of obj ects from models can be automatically scaled based on monitoring the state of the client application 116 and the current frame generation rate while rendering objects of a model.

The client application 116 can run locally on the computer 110, remotely on a computer of one or more remote computer systems 150 (e.g., one or more third party providers' one or more server systems accessible by the computer 110 via the network 140) or both locally and remotely. In some implementations, the client application 116 can be an access point for accessing services running on a platform 145 (e.g., a cloud platform) that support rendering of object model data stored at a database 160 on the platform 145. In some implementations, the client application 116 can implement rendering techniques to adjust the loading and unloading of objects during changes of viewpoints of users within a model that is currently rendered. In some implementations, the computer 110 can impose restrictions on the amount of data that can be processed and rendered when 3D models that are to be rendered are large and take long periods of time (e.g., a minute or two) to load. In some cases, the rendering of large volumes of data can be delayed or even the memory of the computer 110 can crash if the loading operations overwhelm the capacities of the computer to process and render a lot of objects. Such problem can be avoided by implementing rendering techniques that adjust the loading and unloading of objects in accordance with implementations of the present disclosure. By using such rendering techniques, objects from a particular scene within a field of view of a user within the model can be prioritized and filtered to determine a subset of objects that are to be downloaded, loaded, and/or rendered. Also, such techniques can support stable rendering performance at the user device that improves the user experience and is considerate to the memory capacity of the device.

In some implementations, the filtering can be also based on user defined rules associated with types of objects to be prioritized, visibility culling, sorting criteria, and/or post-filtering operations that can be associated with computationally expensive filtering such as occlusion culling. In some implementations, the user selection that can be used for filtering can include user selections of particular object categories such as walls, windows, etc. The user selection may define whether the selected objects are to be excluded or included. In some implementations, visibility culling can be used to filter the objects to download, load, and/or render. The visibility culling can combine multiple volumes which include the field of view of multiple users, the respective zone of confidence, or other forms of space range definitions to determine objects that comply with the filter. In some implementations, sorting of identified objects based on one or more criteria can including sorting based on criteria including distance, size, metadata, zone of confidence, material properties, e.g., material transparency, and/or other characteristics of or for the objects. In some implementations, the filtering of objects can be performed iteratively, using one technique after another, where more computationally expensive techniques can be applied at a later stage, when fewer subset(s) of objects are to be considered, so as to minimize computational costs.

In some implementations, the client application 116 can request to render a model where the model is large enough to not be able to fit in-memory and not be able to keep rendering objects at a frame rate that matches rendering criteria for the user (e.g., a frame rate that is comfortable for an end user and does not cause motion sickness). The FPS is affected by the number of calculations executed on the computer 110 and is independent of the refresh rate. In some instances, the FPS rate can be maintained at a predefined range and limited by the number of polygons that can be rendered. For example, it can be determined to maintain an FPS rate between 40 and 75. In some instances, the FPS rate can be determined to be maintained at a determined range that may be associated with low likelihood for causing motion sickness to a user and is comfortable for the user to immerse in the model environment as rendered. The frame rate is a frame generation rate that measures how quickly a number of frames appears within a period of time (e.g., a second). The frame rate can be computed based on the formula: 1 / (the amount of time taken to render the visible model objects and execute the logic of the client application 116 relative to the latest frame provided to the display device 120 for display). The frame generation rate is distinct from the screen refresh rate for the display device 120, since the screen refresh rate is fixed for the device, and the frame generation rate can vary and loading and rendering of objects can be adjusted to match the frame generation rate and to improve the performance of the rendering by efficiently utilizing the device resources so that the frame generation rate matches the device's frame rate. The applied techniques improve the performance of the client application 116 without negatively impacting the user experience.

In some implementations, when the client application 116 is used to render objects from a model from the 3D model on the database 160 of the platform 145, the client application 116 can obtain a 3D spatial access tree data structure 130 (such as an R-tree data structure) that can be used and processed to inform a loading strategy to select which objects of the model to render when navigating through views and scenes of the 3D model. The loading strategy can be defined to efficiently use the computing resources of the computer 110 to load and unload objects in accordance with an object hierarchy that ranks objects according to priority for their rendering as well as in accordance with a monitored performance of the current rendering, e.g., memory consumption and measurement of the current frame rates). In some implementations, the computation of the priorities, for example, based on considering different factors for the prioritization (e.g., the factors can be optionally weighted), can be executed at the computer 110. In some implementations, the computations of the priorities to rank the objects can be offloaded and executed at a remote system or an external service (e.g., a cloud service that implements the logic of the priorities computations).

In some implementations, the client application 116 obtains a model description (e.g., a model description of a construction design, floor plans, etc.) from the database 160. A user 190 can interact with the client application 116 to initiate or join an already initiated virtual world (a computer-generated representation of a physical world, such as an interior space of a house, a representation of a collaboration space, other) to navigate within the space (e.g., virtual environment) and view the model from different aspects. The rendering can scale any model size based on the implemented dynamic loading strategy as described in the present application. For example, depending on whether the user is scaling in or out, larger or smaller objects can be downloaded, loaded and rendered.

In some implementations, the database 160 can store multi-dimensional data including 3D models, image data, floor plans, etc. In some implementations, the database 160 can include data for users that are associated with access rights for reading, writing, modifying, copying, or other operations to be performed when working with data on the database 160. For example, the user 190 is defined as a user that has access right to the model 134 (and also to model description in the form of the 3D spatial access tree data structure) according to correspondingly defined privileges for the user 190. Access rights and authorizations can be evaluated at the authorization services provided by the platform 145.

In some implementations, the client application 116 can obtain the model description of a model to be rendered on the computer 110 when interacting with visualization services 165 (that may be implemented as part of the platform 145, as separate independent implementations, or as part of the implementation of the client application 116). The visualization services 165 can implement logic to build the model description based on models stored at the database 160, where the model description can be streamed to the client application 116 (e.g., in a communications stream) and used to initialize a loading strategy. In some implementations, the visualization services 165 can provide a model description in the form of a 3D spatial access tree data structure 130 that can be used to generate the loading strategy using loading relevant factors such as a user's viewpoint and distances between objects within the field of view, as well as information for the currently generated FPS and memory usage for the rendering at the user device used for displaying the 3D model. The loading strategy can be applied to the 3D spatial access tree data structure 130 to identifying objects inside a particular volume within the model where a user is located. In some implementations, the loading strategy can include loading relevant factors as a combination to determine priorities for loading objects. The combination of the factors can be weighted combination where different factors can be defined with different weight. For example, the model size and position of the user can be two factors defined with different weights and used to compute a priority (or rank) that can be used to sort objects according to their priority and to prioritize the loading of objects and their rendering on the user device. In some implementations, objects from the model may be downloaded and cached locally based on a determined priority for rendering, which is defined according to prioritization ranking rules based on the tree data structure 130 as well as a current model load limit for the model rendering by the computer 110.

In some implementations, when a user is viewing the model and moves within a virtual environment, the user may have a viewpoint that is outside of the model, and then the model can be seen as small. In those cases, the prioritization of objects of the model to be loaded and rendered would be for objects that are of a relatively bigger size to form the shell of the model, and lower priority will be given to smaller objects. The objects can be ordered based on their prioritization ranking, and those objects that fit into the current model load capacity can be determined and downloaded for rendering. In some implementations, when a user navigates inside the virtual environment, the objects within the field of view of the user (or within a threshold distance around the field of view of the user) can be prioritized for loading and rendering and even smaller objects can be loaded while keeping at least some of the objects forming the shell of the visualized space (e.g., floor or a room of a building) also loaded. The ranking of objects can be dynamically changed based on repositioning of the user as well as based on monitoring the memory consumption and frame generation rate (e.g., within a given time period, e.g., between two updates of a loading strategy).

In some implementations, the client application 116 can be operated using one or more input devices 118 of the computer 110 (e.g., keyboard and mouse). Note that while shown as separate devices in FIG. 1, the display device 120 and/or input devices 118 can also be integrated with each other and/or with the computer 110, such as in a tablet computer (e.g., a touch screen can be an input/output device 118, 120). Moreover, the computer 110 can include or be part of a VR or AR system. For example, the input/output devices 118, and 120 can include a VR/AR input controllers, gloves, or other hand manipulating tools 118a, and/or a VR/AR headset 120a. In some implementations, the input/output devices can include hand-tracking devices that are based on sensors that track movement and recreate interaction as if performed with a physical input device. In some implementations, VR and/or AR devices can be standalone devices that may not need to be connected to the computer 110. The VR and/or AR devices can be standalone devices that have processing capabilities and/or an integrated computer such as the computer 110, for example, with input/output hardware components such as controllers, sensors, detectors, etc. The VR and or AR devices, either connected to the computer 110 or being standalone devices that integrate a computer (with processor and memory) and can communicate with the platform 145 and immerse users connected through these devices into a virtual environment where 3D models of objects can be presented in a simulated real-life physical environment (or substantially similar environment) and users navigate within the environment and are presented with different visual objects.

In some implementations, the system 100 can be usable to display data from 3D documents/models that can be used to generate a virtual world presented in a corresponding interface of the client application 116 (which can be a VR environment for one or more first users, an AR environment for one or more second users, and a non-VR-or-AR environment for one or more third users) that allows users to use the data to navigate and interact with the environment to move to different positions in the space of the virtual world.

In some implementations, the platform 145 can be a cloud platform that can be accessed to support cloud services (such as the visualization services 165 that can be implemented as part of the platform 145) that relate to data visualization in different display modes and can support tools and techniques to interact with the data to navigate in a display mode.

In some implementations, the user 190 can cause the computer 110 to render a view 133 of a model that is presented on a user interface 132 of the display device 120 and visually shows how he/she (or another user) interacts with the view, wherein the view is generated based on processing the 3D spatial access tree data structure 130 for the model. The display device 120 can render a particular view of the virtual world while the user is navigating within the model and is changing his position. In some implementations, the user 190 can be provided with the view 133 as a presentation of a view of a 3D model 134 via VR devices or other AR devices, where the user's view of the model on the user interface 132 can change while the user is navigating in and interacting with the model. For example, the view 133 can change based on user interaction with the interface 132 to move the user closer to the model.

In accordance with implementations of the present disclosure, the rendering of the model 134 and at least some of the objects of the model 134 can be performed based on the dynamic loading strategy for loading objects of the model 134 in accordance with a viewpoint of the user (including the position and orientation of the user), an object hierarchy as defined based on ranking objects according to a prioritization criterion for rendering objects (e.g., where the ranking is performed based on the 3D spatial access tree structure), and a current model load limit. In some implementations, the current model load limit can be maintained up to date by monitoring the current frame rate for the rendering and adjusting the model load limit to scale the rendering to the frame rendering speed.

In some implementations, the loading strategy monitors the health of the system, where the quantity threshold for loaded objects can be adjusted based on the amount of complexity of data (e.g., some objects are more complex and are associated with higher processing costs, e.g., transparent objects or complex material objects) that is feasible to be able to be rendered. For example, if the FPS at a given time are lower than a specified model load limit for a number of frames, it can be understood that the system is reaching the limit of the rendering capacity that can be supported. In some instance, the model load limit for the number of FPS can be adjusted and lowered based on the distance between the current load limit and a mean value for the currently monitored FPS rendered during a last monitored period. In some instances, the distance can be determined as a normalized distance between the FPS average value during a current monitored period and a minimum comfortable FPS that the system targets multiplied by a current amount of loaded geometry. In some implementations, the loading strategy applied to determine which objects to render can be implemented to add the ability to boost positive trends in the rendering and slow down negative trends. In such case, the loading can be speed up by increasing the velocity for loading when there are positive treads in the performance of the loading at the user device, and the loading can be slowed down to lower the velocity, when it is determined that data is to be unloaded in accordance with observed performance at the user device (e.g., higher frame generated rate compared to a threshold level for considering to start unloading). Such auto-tuning of the loading strategy can be performed based on the observed current FPS rate at the user device and a target FPS rate. Further, the auto-tuning can be configured to perform the unloading slower when it is determined to initiate unloading and to increasing the speed of the loading when it is determined that more objects can be loaded based on the current frame rate. As described, the loading and unloading is performed in an adaptive manner that optimized the computational resources and is balances against the frame rate per second that is experienced at the user device.

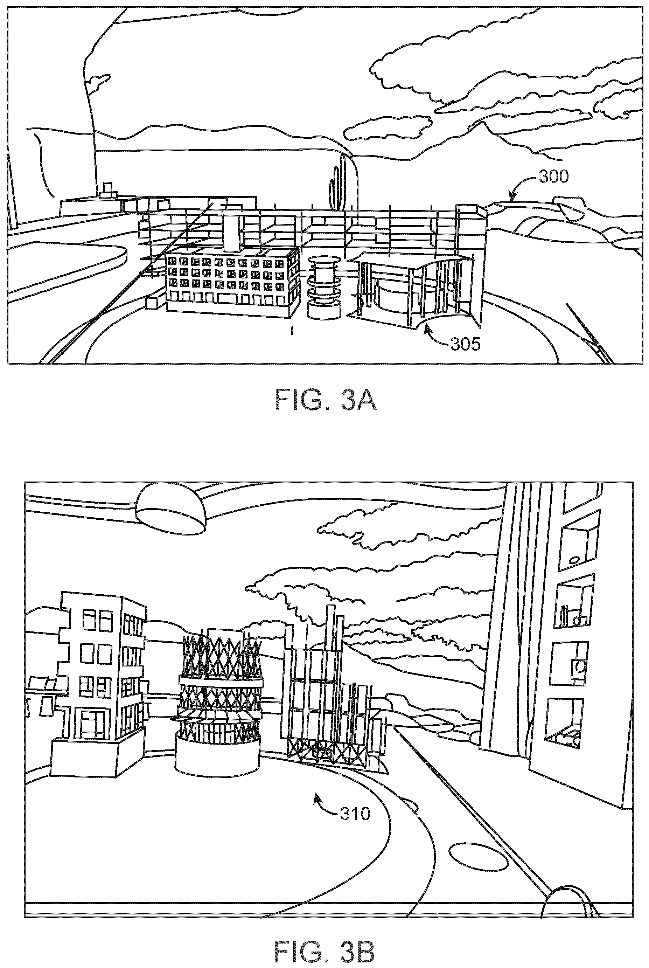

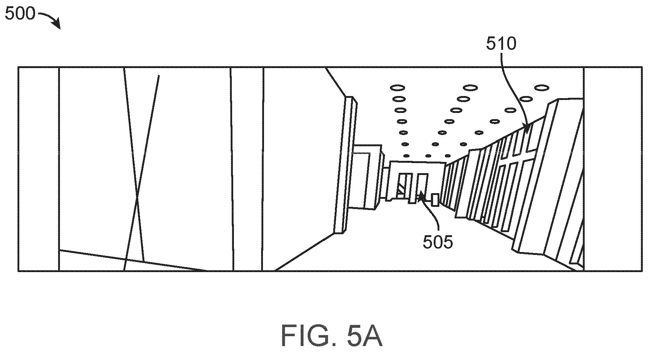

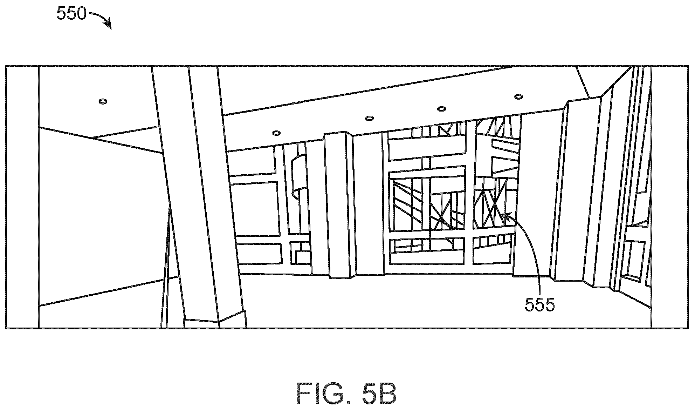

The systems and techniques described herein are applicable to any suitable application environment that can graphically render any portion of a virtual world, including the objects therein. Thus, in some implementations, model data from models stored at the database 160 can be used for rendering objects in different modes and accessed from multiple types of devices, where a user can navigate within the virtual environment where the model is rendered, for example as described in relation to FIGS. 3A, 3B, and 5.

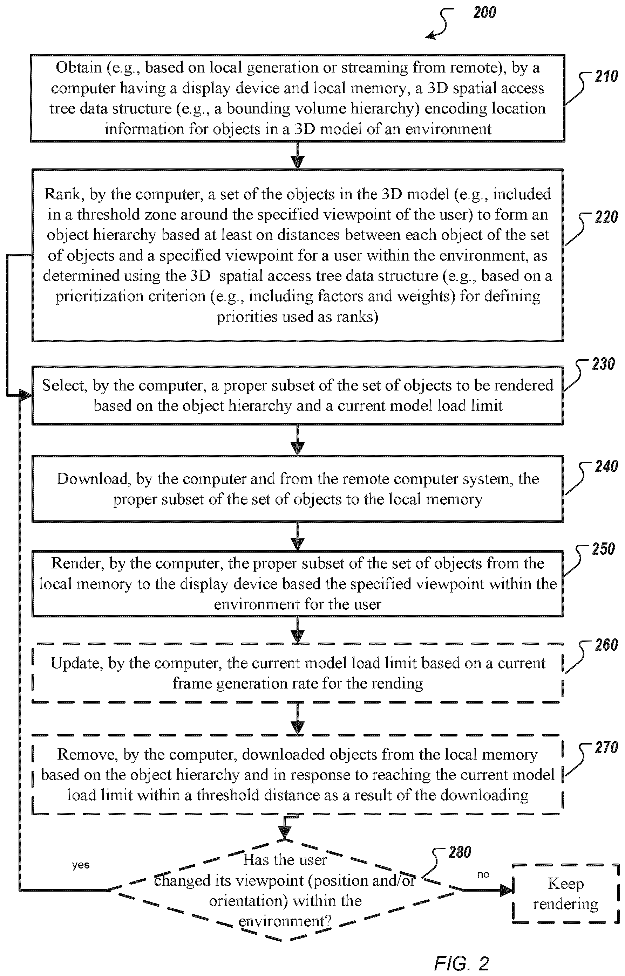

FIG. 2 shows an example of a process 200 to navigate around and within a 3D model of an environment that is rendered according to a dynamic object loading strategy that efficiently utilizes resources at a client device to render the model in accordance with implementations of the present disclosure.

In some implementations, navigation within the 3D model can be in the context of user interaction in a video game. In some examples, when a game is built, created objects and scenes are used to generate three-dimensional models that can be defined for different layout levels and based on script gameplan. The game may be accessed from a computer for rendering. In some implementations, the rendering can be in a virtual 3D model environment within which the user is positioned. In some implementations, a model of a game can be built to include tiles that can be dynamically loaded while the user plays the game on the computer. The 3D model of the game is rendered, and if the model is a large model, the rendering of the model in full can be a time consuming and a resource expensive task. The model loading may not be possible to be performed within the cache of the computer, for example, the computer can be of a user device that does not support heavy computations and large data storage.

With increasing the complexity and the size of a three-dimensional model, the scalability to render the model can decline and affect the performance and the user experience during the rendering, for example, during a VR game. Cases where the complexity of models is growing and rendering of data can be costly and hardware restricted may require considerations for optimization of the loading and unloading of objects. In some implementations, when a game is rendered, it may not be necessary that all the objects are initially loaded but rather the loading and rendering can be optimized and dynamically adjusted to the position of the user in the environment and a current model load limit that can be auto-tuned to the performance of the rendering by the computer.

In some implementations, 3D models can be generated and used for rendering in various contexts. In some implementations, a user can generate, create, or upload a model of a physical entity or environment that includes various objects and space organization. The generated model can be provided by a platform and can be accessible through various access points, such as different user interfaces that can be accessed via desktop devices, mobile devices, other devices, services, or other entities. For example, the 3D model can be of a building including a 3D geometry, metadata, and floorplans. There can be multiple hierarchies within the 3D geometry based on the spatial distribution of the model (e.g., bounding volumes of each part of the model, starting from the outside), but also on the metadata (e.g., building - > floor -> room).

At 210, a 3D spatial access tree data structure is obtained (received or generated) by a computer having a display device and local memory. In some implementations, the 3D spatial access tree data structure is substantially similar to the 3D spatial access tree data structure 130 of FIG. 1. The 3D spatial access tree data structure is a data structure including model description for a 3D model that includes location information for objects in the 3D model of an environment. The 3D spatial access tree data structure is obtained at the computer that is a user device used for rendering the 3D model. The 3D model is stored on a remote computer system, for example, at a platform such as the platform 145 of FIG. 1.

In some implementations, the generation of the 3D spatial access tree data structure can be performed at the computer or can be invoked from an external service (e.g., a cloud service) that can generate the tree data structure based on model data for the 3D model. In some implementations, the 3D spatial access tree data structure can be received from another computer, that can be different from the remote computer system where the 3D model is stored. The obtaining can include streaming of the data structure from another computer and/or through a service, where the data structure can be generated from received model description of the 3D model.

In some implementations, the 3D spatial access tree data structure can be obtained for a 3D model when a user of the computer initiates opening of the model, and model description data can be collected and cached at the computer. The 3D spatial access tree data structure can be used to initialize a loading strategy for rendering objects of the model at the computer. The 3D spatial access tree data structure can be built based on obtained model description data for the 3D model. The 3D spatial access tree data structure can include a bounding volume hierarchy that is computed to include nodes corresponding to bounding volumes defined for respective spatial portions of the environment (e.g., floors or rooms of a 3D model of a building). The bounding volume hierarchy can include leaf nodes that correspond to the objects in the 3D model of the environment. The bounding volume hierarchy can be built as a structure that can be queried to support efficient spatial queries that are executed when determining which portion of the objects of the 3D model to load for rendering based on the position of the user in the 3D model in the environment. When the computer determines what to render for a user positioned in proximity to the 3D model in the virtual space, the computer can efficiently determine a set of the objects to be loaded and rendered based on the position of the user, the size of the model, and the processing capacity of the user device (e.g., model load limit for rendering frames at the computer).

At 220, a set of the objects in the 3D model are ranked to form an object hierarchy based at least on distances between each object of the set of objects and a specified viewpoint for a user within the environment. In some implementations, the specified viewpoint for the user can include user's position and orientation of the user's camera at that position.

In some implementations, the set of objects can be determined by querying the tree data structure to determine objects that are within a "zone of confidence" around the position of the user within the environment. Such a zone of confidence can be considered as an area within a threshold range around a specified viewpoint of the user within the environment. In some implementations, the zone of confidence can be defined as a volume of a given shape such as a sphere, capsule, or frustum, among other example shapes). In some examples, the zone of confidence can be considered as a room of a building (as an example 3D model) that a user's camera view (e.g., user's avatar in the 3D environment) is currently viewing from the inside of the room. In some implementations, once the set of objects are determined, those objects can be ranked based on computing distances between each object and a specified viewpoint for the user within the environment, so that closer objects can be provided with a higher ranking (or priority). The distance between an object and the specified viewpoint of the user can be determined using the 3D spatial access tree data structure and the location information for the objects of the model thereof.

For example, when the viewpoint of the user is specified, objects that fall within the direct field of view of the user can be determined, however, there may be objects that are in direct proximity to the user that do not fall within his field of view (e.g., directly at the back of the user) or there may be objects that are hidden by other objects but still in close proximity to the user. In some implementations, querying the tree data structure can provide the set of objects that fall within the zone of confidence of the user and can be objects that can be either visible or hidden for the user from his specified viewpoint. In some implementations, the loading strategy can be configured to determine the zone of confidence as an area around a user's avatar (the position of the user viewing the 3D model in the environment) within the 3D environment. In some cases, the zone of confidence can be defined to include object that can be outside of the viewing perimeter of the user's camera but that are within a close proximity (e.g., defined in relation to a threshold distance for filtering close objects) to the position of the user). For example, if a user is currently positioned inside a room of a building and has an orientation towards the inside of the room, the zone of confidence for the user can be determined to include objects that are directly behind the user and not visible to the user, but if the user makes a turn or switches his orientation, such an object can quickly become part of his viewpoint and become visible for the user. Further and for example, some objects may be occluded even if falling within an area around the user and user's viewpoint. Such objects may not be necessary to be immediately rendered since they are not visible from the current viewpoint of the user, but because of the close proximity or other factors, it may be considered to include those objects in the zone of confidence and consider them for ranking and prioritizing which objects to load. In some implementations, the objects from the zone of confidence are ranked according to the loading strategy, which can be configured to consider for rendering object that are occluded or not immediately in the viewing zone of the user. Such preemptive loading that can be done in consideration of the positions of the user, size of the model and the objects, and the FPS and memory consumption of the rendering device can support smooth rendering during the process of a user moving within the 3D space, where abrupt changes in direction can be made. The query for the set of objects is executed to determine objects of all the objects of the 3D model (and respectively the leaf nodes of the tree data structure) that are to be rendered in a specified volume (e.g., a frustum, a capsule, or other). In some implementations, occlusion mechanisms can be implemented to be able to determine the objects that are within the zone of confidence but not visible would have to be ranked lower. The occlusion mechanism can be implemented once the objects are prioritized and before the selection of objects for rendering is made.

In some implementations, the set of objects are provided with ranks corresponding to priorities for their loading. The priorities can be defined according to a priority rule (and a prioritization criterion) that can be used to weigh the model size and the distance of an object to the position of the user. Further, in some cases, the priorities for the objects in the zone of confidence can be computed with consideration for the visibility of objects (e.g., falling completely within the "zone of confidence," being occluded or partially occluded by other objects) from the specified viewpoint of the user. Thus, objects that are in close proximity to the user but fall behind another object and are obfuscated (partially or completely hidden behind an object or based on the shape of the volume) and/or are behind the user and do not fall into the viewing area but still are in close proximity, can be considered by the loading strategy and ranked according to the loading strategy. In some implementations, the prioritization criterion for the object loading can define factors associated with prioritizing loading of a first object compared to loading of another object. In some implementations, the prioritization can be based on user defined criterion related to object properties. In some cases, metadata for the objects can be stored to include a category of the object, e.g., wall, stairs, pipes, etc. In some more cases, the metadata for the object can also include metadata for the location of the object within the environment such as a current floor or room where the object is located. The factors comprise a comparative ratio between a size of an object and a size of the model, the specified viewpoint of the user, the distance between each object of the set of objects and the viewpoint for the user, a location of the user within the three-dimensional model, comparative position between each two of the objects within the environment from the viewpoint of the user, and physical properties of the object (e.g., objects made of materials that are see through, i.e., transparent, shader complexity, or other precise metrics for physical characteristics of the object). For example, based on the position of the user, a set of objects can fall into the direct viewing perimeter of the user, where some object that are located within that area can be occluded by others. In some cases, the occlusion can be partial as some objects can overlay some other objects without fully covering them. Further, in some cases, some objects may have physical properties such as being transparent or reflective (e.g., they can be of semi or fully transparent material (e.g., windows, glass doors, crystal vase, other) or reflective as a mirror). Some or all of these factors can be considered when generating a loading strategy, where in some cases even dynamic modification of which factors to include in the loading strategy and at which iteration can be determined during runtime. The prioritization criterion can be defined as a weighted combination of two or more of the defined factors, wherein each factor of the two or more factors is associated with a pre-defined weight for the combination.

In some implementations, the objects that are determined at 220 can be filtered to provide a subset of objects that are relevant for the current rendering so that the loading can be performed for that subset of the objects as they are of higher importance.

At 230, a proper subset of the set of objects is selected by the computer to be rendered based on the object hierarchy and a current model load limit. The selection is performed based on filtering those of the objects that are with the highest priority (as determined by the ranking) and fit into the current model load limit.

In some implementations, the determination of the proper subset can be performed at an external service or platform, where the computer can exchange information with a visualization service or platform (such as the visualization services 165 of FIG. 1 or the platform 145 of FIG. 1) for objects that are to be visualized. In some cases, the filtering and determining which objects are to be rendered by the computer at the display device can be performed at such an external service or platform.

At 240, the proper subset of the set of objects is downloaded to the local memory of the computer. At 250, the proper subset of the set of objects are rendered from the local memory to the display device based on the specified viewpoint within the environment for the user.

At 260, the current model load limit based on a current frame generation rate for the rendering is updated. In some implementations, the current frame generation rate is monitored and updates to the load limit are performed periodically or dynamically, e.g., based on identifying an event such as based on a detection of a change in the rate that exceed a threshold value.

At 270, downloaded objects that are cached at the local memory can be removed from the cache based on the object hierarchy (e.g., and respective ranks for the objects) and in response to reaching the current model load limit within a threshold distance as a result of the downloading. In some implementations, the downloaded objects are a proper subset that includes a number of objects that is above or reaching close to the load limits for rendering frames. Thus, the loading strategy can include dynamic unloading steps that include lowering the model load limit that can result in lowering the quantity of objects that are to be kept in the cache of the computer. Thus, at least some of the already downloaded objects may be removed in response to reaching the current model load limit within a threshold distance.

For example, the current model load limit can be defined as an FPS rate and a memory usage percentage of the CPU/GPU that should not be exceeded. In some instances, the FTS rate can be set as acceptable within a range, e.g., between 40 to 75 FPS, and the memory usage can be set as acceptable to up to 80% to allow the user device to smoothly render objects during user's navigation within the space even if some of the objects that need to be loaded have not been pre-loaded. In some implementations, the threshold distance defined around the current model load limit can be defined as a distance between the highest acceptable FPS and percentage for the memory usage and the currently observed metrics. For example, the distance between the highest acceptable FPS and the currently observed FPS can be set to 5 or 10 FPS, thus when the FPS reaches 65 or 70 FPS, the loading strategy may consider starting to remove objects as discussed in relation to step 270. The threshold distance can be defined as a percentage below the highest acceptable load for the memory of the CPU/GPU that can be for example, 5% or 10% below the highest acceptable value (e.g., 80%). It should be appreciated that these are only example threshold values and example highest acceptable metrics, which can be configured to different values and used in the loading strategy to determine when and whether to remove objects as described at 270.

At 280, it is determined whether the user has changed its viewpoint. For example, it can be determined whether the user has changed his orientation without changing the position, changed the position and kept the same direction of viewing, or changed the position and the direction of viewing. If the user has changed his position and/or orientation, the steps of selecting, downloading, rendering, updating, and removing, are iteratively repeated as changes to the specified viewpoint within the environment for the user are received. The user navigates within the environment and changes his/her viewpoint, thus different sets of objects are relevant for ranking, as the distance between objects and the new viewpoint of the user has changed. The steps are iteratively repeated during the interaction and movement of the user with respect to the 3D model. If at 280, it is determined that the user has not changed their viewpoint, then the rendering of the proper subset of the set of objects is maintained. In some instances, determination that the user had changed their viewpoint can be made based on receiving a notification for the interaction of the user with the 3D space to move and/or change orientation in the 3D space.

FIGS. 3A and 3B show example user interactions for navigating within a spatial view of a VR environment rendered at a display device by a client device in accordance with implementations of the present disclosure.

On FIG. 3A, a user interface of a client application, such as the client application 116 of FIG. 1 is presented where a 3D model of an environment is rendered. In some implementations, the model rendering is performed in response to a user interaction to request access to the 3D model from another platform or service. In some implementations, a user can access a platform storing 3D models and data for visualization of the models. The access to the 3D model can be done through different access applications or through a web browser (or other access point). In some implementations, a user can enter a VR environment representing a model of a building, that is rendered at the user interface. The user interface can provide tools and options for rendering the model or portions of the model while the user moves within the environment. In some implementations, as shown at FIG. 3A, the model is rendered from the outside and from a viewpoint of the user. In some implementations, the application used for rendering the object can be configured to execute the method of FIG. 2 to render objects of the model in accordance with a dynamic loading strategy considering the viewpoint of the user and a model load limit of the client device used for the rendering.

In some implementations, the rendering at FIGS. 3A and 3B are based on obtaining 3D spatial access tree data structure and ordering and filtering objects based on an object hierarchy defined according to a priority rank and a current model load limit. The obtaining of the tree data structure, as well as the ordering/ranking and filtering/selecting can be done in substantially similar manner as described in relation to the steps 210, 220, and 230 of FIG. 2.

In some implementations, the user can navigate within the space and define a position within the model that is of viewing interest. For example, the definition of a position can be performed based on interactions such as hand-based interaction with VR user devices, or with a mouse and a keyboard of a computer. In some implementations, using sensors on a headset of a user interacting with the VR environment, the application can map the user's real-world desk to their virtual desk within the virtual experience when displaying the 3D model. In some implementations, a virtual user interface can be provided to allow the user to select a model for review in the virtual space, where the user can point to portions of the model to switch his/her position.

In some implementations, based on the distance of the user to the objects of the 3D model and the current load limit for rendering frames by the user device, different views of the 3D model can be provided. In some implementations, the decision for the loading and rendering of objects while the user repositions themselves with respect to a model of an environment can be performed dynamically in accordance with the implementations of the present disclosure, and for example, as described in relation to FIG. 2.

For example, FIG. 3A includes a presentation 300 of a 3D model that is shown from a larger distance from the viewpoint of the user, compared to the distance from the viewpoint of the user at FIG. 3B. In some cases, the presentation at FIG. 3A can be referred to as the "dollhouse model" or a "scaled model" view. Since the user is further away from the model on FIG. 3A, the objects that are determined to be rendered as described in FIG. 2 can be objects that match with the proper subset as selected at 230, FIG. 2, and those are a set of objects that are with highest rank for priority for rendering and are selects based on a current model load limit.

In accordance with implementations of the present disclosure, a loading strategy can be generated for the 3D model, where at a certain point in time and at a certain position and orientation of the user within the environment, the user is presented with the representation 300 of the 3D model. As discussed, this is the representation 300 that is seen from outside of the model building. In the example of FIG. 3A, when the user's position is outside a building, the user may not see all or some of objects inside the building even though they are not occluded. For example, the building has windows and those can be transparent so that one can generally see through the windows and be able to see an object in the rooms spread over the floors (e.g., the user should be able to see a stove in a kitchen (or other room) through the window of the building). However, a loading strategy for rendering the representation of the building can be generated to prioritize the shell of the building (as closer to the user's position and falling in the user's zone of confidence) in view of the distance between the building and the user. Thus, when the building is rendered, the objects as ranked from the zone of confidence of the user can be filtered based on constraints of the rendering device. As previously discussed, the filtering can be with consideration of whether there is enough memory available to load the objects inside the building and to identify a portion of the objects ranked with the higher ranks for relevance (priority) for rendering and first render them as shown on FIG. 3A. The objects that are presented at FIG. 3A are objects that are considered closer to the position of the user and define a shell of the model, thus, the objects are ranked higher as they are bigger objects.

In some cases, while viewing the presentation 300 of the building model the user may be interested in navigating closer to a portion of the model, for example, the lower down right region 305 of the building. That portion of the building as shown on the presentation 300 is rendered to include bigger objects that can be seen from the outside while smaller objects inside the building, even if they can be seen through the windows, are not shown. To view in further detail that portion 305 of the presentation, the user may navigate in the 3D space to reposition himself/herself and adjust the direction of viewing. For example, the viewing point (i.e., the position of the user and the direction of viewing) can be moved to the viewing point of the user associated with the presentation 310 of FIG. 3B. In that new presentation, based on the loading strategy, different objects associated with that portion of the model are rendered. Due to the change of the distance of the user to that portion of the model, smaller objects that fall within the zone of confidence of the new viewpoint can be considered and ranked according to the loading strategy.

In some more cases, and as further discussed in relation to FIGs. 5A and 5B, if a user navigates within the 3D space and is inside a room in the building (e.g., the building of FIGs. 3A and 3B), the user may not see objects outside the building through the windows (as shown on FIG. 3A) even though they are not occluded (e.g., a tree outside of the building that can be seen through the window in the wall of the room) without moving closer or directing his view towards the windows (FIG. 5B). Such prioritization of objects to be rendered or not is a result of executing a loading strategy where the determination of the zone of confidence for a given viewpoint can force downloading of all nearby objects in the room (be those small or big) which can occupy the memory and not allow space for loading objects outside the room that should be visible based on the viewpoint. In some cases, if the user changes his location, e.g., closer to the window, the tree outside the room may move to the zone of confidence and be considered for loading and rendering in accordance with the implementations of the present disclosure.

The objects that are presented at FIG. 3B are objects that are considered closer to the new position of the user, which is closer to a particular portion of the model and thus from that position of the user, a different set of objects can be considered as relevant and ranked based on their distance from the position of the user. In the case of FIG. 3B, smaller objects may be rendered because they are positioned closer to the position of the user. As described in the present disclosure, the determination of which objects to render is made based on an object hierarchy defined for objects that fall into a zone of confidence around the field of view of the user and a load limit for a number of frames to be rendered. The rendering can be autotuned dynamically by adjusting the selection of objects to be downloaded and rendered based on the current model load limit. Further, the rendering of frames can be monitored, and the limit can be adjusted in accordance with a current frame rate while at the same time keeping the frame rate within a range that would not affect the user experience (e.g., cause motion sickness). As such, the 3D model can be loaded progressively on a pedestal defined at the user interface at a sufficient level of detail that will not affect the application's performance (e.g., ~60 FPS and low latency) and will always show a high-level representation of the model, such as a full "shell" (or outside view) of the model.

In some implementations, based on determining a change in a location of a user within the environment, as can be determined in FIG. 3B that is a subsequent view of the environment after rendering the view of FIG. 3A, new ranking of objects in the environment can be performed, where the ranking can be repeated for new objects that are determined based on querying the tree data structure and performing ranking according to prioritization criteria. In some implementations, the repeated ranking can be for objects that at least partially include objects that were previously loaded, e.g., for the view of FIG. 3A, however, the overlapping objects may be ranked with different priorities based on the changed location and potential indications for the model load limit (or updates thereof). If a previously ranked and downloaded object for the rendering of FIG. 3A is also selected for loading and rendering at FIG. 3B, that object may not be needed to be downloaded as it can be still in the cache of the device. Thus, if the loading strategy can support loading of further objects that are not immediately rendered for a particular scene, if the loaded objects are relevant for a subsequent scene, the rendering operations can be optimized, and the performance can be improved.

In some implementations, the loading of objects of the 3D model and rendering them at the display device can be at least partially determined based on the memory consumption needed for the rendering as well as a monitored measurement of frame rates per second when rendering views from the model. In some implementations, the level of detail that is applied when rendering a 3D model can be dynamically determined based on dynamic adaptations or adjustments to the loading based on the current frame generation rate for rendering. Such dynamic considerations can support faster loading and slower unloading of objects that are downloaded into the cache to support efficient utilization of the resources that allow to render first objects that are already cached (thus faster to render) compared to objects that have not yet been downloaded but could be relevant for a new position of a user during interaction with the environment and repositioning.

In some implementation, when the 3D model is presented, a portion or all of the 3D data related to the model can be downloaded and used for the rendering. For example, the different level of detail that is relevant for rendering the 3D model can affect the amount of data that is downloaded for the data visualization. By reducing the amount of data to be downloaded, network bandwidth can be conserved. In some implementations, a user may configure a level of detail that is relevant for the presentation of the data at a particular user interface used by the user to show a 3D model and based on such configurations, not all but some of stored 3D data for a 3D model can be downloaded. Such filtering of the amount of data to be downloaded can be dynamically adjusted or can be iteratively trained based on evaluation of user interactions.

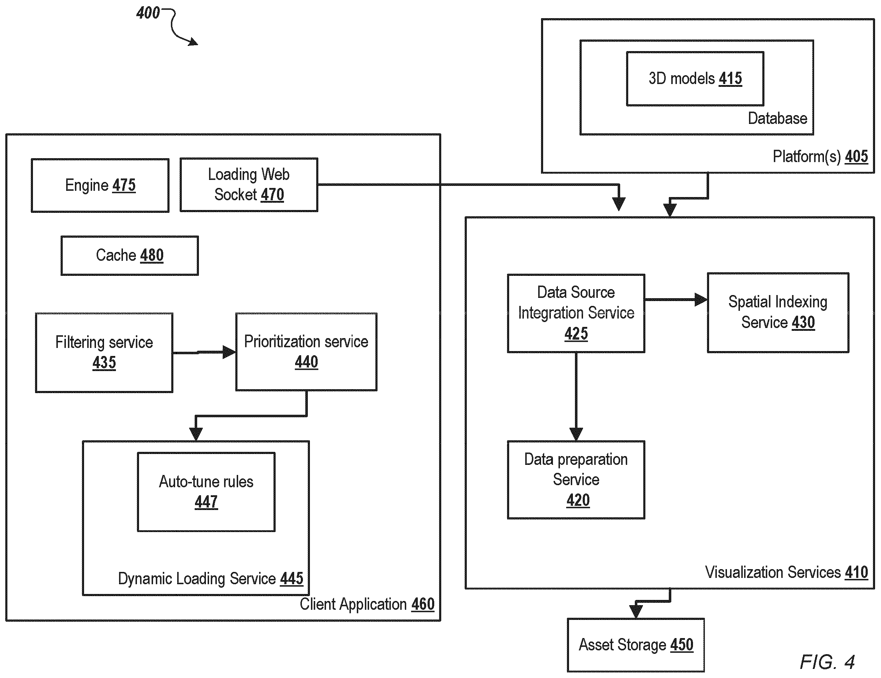

FIG. 4 shows an example system architecture 400 of a client device used for rendering 3D models based on an adaptive dynamic loading strategy in accordance with implementations of the present disclosure. In some implementations, a client application 460 can be substantially similar to the client application 116 of FIG. 1, and the client application 460 can be configured to execute at least some of the steps of the method 200 of FIG. 2.

In some implementations, the client application 460 can be configured to execute a dynamic adaptive loading strategy to determine which objects of a 3D model to download locally and render. The loading strategy can be defined to scale rendering of large models that cannot be downloaded in full in the cache. In some implementations, the client application 460 may request to present a model from the 3D models 415 of the platform 405. The platform 405 can be substantially similar as the platform 145 of FIG. 1 and may be considered as the remote system of FIG. 2, where objects of the 3D models can also be downloaded.

In some implementations, the client application 460 can request to open a model from the 3D models 415 and fetch the model description to generate a 3D spatial access tree data structure encoding location information for objects of the 3D model or to directly obtain the 3D spatial access tree data structure. In some implementations, the client application can directly download it from the platform 405 if the platform had generated it or from visualization services 410 that can connect with the platform 405 and generate tree data structures from models 415.

In some implementations, the visualization services 410 can be implemented as a separate set of services or can be integrated into the logic of the client application 460. The visualization services 410 can include a data source integration service 425 that can be configured to collect model description data for a model(s) from the models 415 and provide the model description data to a data preparation service 420. The data source integration service 425 can provide an abstraction layer on top of data sources (e.g., sources of models) to obtain properties associated with objects and implementations within models, as well as identifiers for faces and vertexes in the models. The data source integration service 425 can be used in connection with the data preparation service 420 to query data associated with the models and determine level of details of objects from the model.

The data preparation service 420 can be configured to implement logic to pre-compute some properties from metadata for 3D models that can be used for optimization of the data processing and determination of prioritization for loading an object or not when performing the selection of objects (e.g., as described in relation to steps 220, 230, and 240 of FIG. 2). The data source integration service 425 can collect the properties for the models and objects, including data for texture, material details, pixel color, or other data. In some implementations, such data for textures, material details, and other metadata for 3D models can be stored at an asset storage 450 accessible by the visualization service 410. In some implementations, a spatial indexing service 430 can generate the 3D spatial access tree data structure (e.g., a bounding volume hierarchy structure). In some implementations, the data preparation service 420 can be in communication with an asset storage where files for different three-dimensional scenes and models are stored (e.g., in various file formats such as gITF, a DirectDrawSurface (DDS) file, or another format).

In some implementations, the data source integration service 425 can be communicatively coupled with the spatial indexing service 430. In some implementation, the spatial indexing service 430 can generate a tree data structure including objects of the model as leaves together with their location within the model. The spatial indexing service 430 can initialize the hierarchy information and store it locally or at a remote storage, where the generated tree data structure can be queried to obtain the prioritized objects within a given volume. By querying the generated tree data structure, a result non-ordered list of a set of identifiers of the objects can be obtained. In some implementations, the list can be used to obtain the objects based on the data at the data source integration service.

In some implementations, when the client application 460 connects with the visualization service 410, a loading web socket 470 of the client application 460 can be used to connect with the visualization services 410 to open a model and to render objects on a display device (not shown). Upon receipt of a request at the visualization services 410, the spatial indexing service 430 can generate a list of non-ordered identifiers of objects associated with a given viewpoint of a user and the requested model and provide the list to a prioritization service 440 that can perform ranking (e.g., substantially similar to the ranking described for step 220 of FIG. 2). The prioritization service 440 can implement logic to sort a set of objects based on a set of prioritization rules that can be defined for the client application 460 (e.g., as an external input for a particular rendering, or as configurations for default settings in the client application). In some implementations, the prioritization rules can be defined at the client application at different granularity for different target users (e.g., user roles, user groups, etc.)

In some implementations, the rendering of objects of the 3D model can be performed in the context of the user being in an interaction with another user in the space (e.g., playing a game, collaborating on a task), where the other user interacts with another device where objects of the 3D model are displayed. In some implementations, each of the two users navigate within the 3D space and being displayed with rendered objects as determined at each of their devices. The two users can rely on loading strategies that are separately used to determine which objects to load. In some implementations, for each of the two users, a zone of confidence (as previously discussed) can be determined. In some cases, the zone of confidence of one of the users can be determined with consideration of what is determined as "the zone of confidence" for the other user. For example, if one of the users has object A in their zone of confidence, the other's user zone of confidence may be expanded (if not already including that object A) to include object A. The determination of whether to adjust one's zone of confidence relative to another user can be defined based on configured importance rules, which may include use roles in the application (e.g., two players of the same game, users of connected roles, etc.) or based on the proximity between their locations and/or orientation one to the other. For example, if two users are positioned within a threshold distance in the same room of a building and their orientations are facing one another, the determination of a zone of confidence can be performed with consideration of the position and orientation of the other user, and/or also constraints from the rendering at the client device (e.g., memory consumption and FPS).

The prioritization rules can define weighting factors for generating a rank for each of the objects based on considering multiple factors including the position of the user and the distance of the user from objects, the size of the model and relativeness to the size of the objects, the viewpoint of the user (including user's position and orientation), a definition of a "zone of confidence," and a model load limit initial configuration for scaling the rendering by the client application 460. The prioritization service 440 can process the input list of non-ordered identifiers of objects and generate as output an array of ordered identifiers of objects that can be obtained and loaded in the cache 480 from the data source integration service 425. In some implementations, the data source integration service 425 can be implemented as part of services provided by the platform 405. In some implementations, while the data source integration service 425 is supported from the platform, the data preparation and the tree data structure generation as implemented at the data preparation service and the spatial indexing service 430 can be implemented as external services or as part of the services implemented by the client application 460.

In some implementations, the prioritization service 440 can provide the output ordered list to a dynamic loading service 445 that can implement auto-tune rules 447 for dynamically determining the quantity of objects to be loaded and rendered based on the frame rates per second as monitored at the client application 460 and/or based on the memory consumption of the client application 460 while processing and loading objects for rendering. The auto-tune rules 447 can be iteratively processed, for example, when a set of objects are rendered, to update a current model load limit based on an observed current frame generation rate for the rendering.

In some implementations, the dynamic loading service 445 can maintain a state defining which objects are loaded and unloaded as well as pending operations on the client side since the latest update of the model load limit. The dynamic loading service 445 can implement filtering rules to determine which subset of objects from those that are in the output ordered list are to be downloaded in the cache and rendered at the display device. The dynamic loading service 445 can be configured with tools to compute a current state of the loading and unloading for a monitored period of time and in relation to a given session for a user interacting with a model, and leverage information from the spatial indexing service 430 and the filtering service 435 for a loaded model to selects those objects that conform with auto-tune limits defining the current model load limits (that are automatically adjusted based on a current frame generation rate for the rendering). Based on the determined identifiers of objects by the dynamic loading service, the objects can be invoked through the data source integration service 425 and downloaded at the cache 480.

In some implementations, when properties of objects and the objects are downloaded, the engine 475 of the client application can render the determined subset of objects as downloaded in the cache and render scenes including the objects at the display device.

FIGs. 5A and 5B shows examples of user interactions with a user interface including presentations 500 and 550 of 3D data for a 3D model provided by a client application on a user device. The presentation 500 of FIG. 5A can provide tools for navigating within a 3D model of an environment where objects are rendered according to an implemented adaptive dynamic loading strategy in accordance with implementations of the present disclosure. The user interface 500 can include a view of rendered objects from a model that is the same model as the one associated with the rendering displayed on FIGS. 3A and 3B. In some implementations, the user may navigate based on interaction with the menu options provided at the user interface 500 to move inside the model and be provided with rendered objects associated with his new position, where the selection of the objects to be loaded and rendered, as well as subsequently unloaded based on updates to the current model load limit can be done in substantially similar way as the described method 200 of FIG. 2 that includes iterative repeating of ranking, selecting, downloading, rendering, updating, and removing of objects from the 3D model as the viewpoint of the user within the environment has changed.

When the 3D model is of a building, such as the one presented view of a building at FIGs. 3A and 3B, the shell of the model is a "doll house" representation of the building when looked from outside. Generally, even if the doll-house representation of the 3D model is with a fine grain of detail or with lower level of detail (or anywhere in between), by moving within the environment, a desired portion of the 3D data (that is not fully rendered at the doll-house representation) can be readily identified based on identified user position and kept to a quantity that is sustainable for rendering at the respective device used for the rendering.

A user interacting with the 3D model and navigating within the 3D environment (as shown on FIGs. 3A and 3B) can switch from a viewpoint that is from outside of the building to a viewpoint that is within a room of the building (as shown on FIGs. 5A and 5B). The presentation 500 of the 3D model of FIG. 5A is from the inside of a room that includes a first wall 505 with windows and a second wall 510 with windows on the right. Even though the windows are glass windows and are see through, the presentation 500 does not include all objects that are outside of the building and can be seen. The loading strategy used for rendering the presentation 500 considers the position of the user and the distance between the user and other objects in the room to determine which of the objects in the zone of confidence of the user are to be presented in accordance with observing the current load model limit. The loading strategy did not select all objects that are outside of the windows, and for example, includes some objects on the wall 500, but no objects on the wall 510.

**In** contrast, the presentation 550 of FIG. 5B is from a viewpoint of the user that is closer to the windows on the wall 505 of FIG. 5A. When that presentation 550 was rendered, the loading strategy had considered the distance to the outside objects from the user's viewpoint and the loading strategy was used to select those that are to be loaded on the device and rendered. As shown, the windows 555 are see through windows and based on the loading strategy, the objects that can be seen from the windows are rendered, thus, one can see more objects from within the building model, compared to what could have been seen on FIG. 5A, as some were not selected for loading and rendering when the user had the viewpoint as in FIG. 5A.

As shown in FIG. 5A, when the user's viewpoint is inside a room in a building, the user may not be presented with objects that are outside the building even though they are not occluded (e.g., one should be able to see the other building out the window in the wall of the room) because the zone of confidence when determined and filtered, had forced downloading of all nearby objects in the room, thus leaving no memory for objects outside the room to be downloaded and rendered, even though they should be visible from that viewpoint. In FIG. 5B, the objects outside the window are rendered, because the loading strategy had evaluated a new set of objects to be included in the new zone of confidence and those objects had been ranked based on their distance to the user viewpoint and filtered to fit into the memory capacity of the user device. In this example, the objects that are shown as visible through the window 555 are those of the objects in the 3D model that were filtered to be included for downloading and rendering as ranked according to the loading strategy.

By determining which objects to be loaded and rendered according to a dynamic adjustable loading strategy in accordance with the present implementation, flexible yet efficient switching between different display modes and different levels of data to be rendered can be supported. As shown, the loading strategy can determine some objects to be rendered when a user is viewing from outside of the model (as shown in FIGs. 3A and 3B), and the loading strategy can determine which objects to be rendered and which objects to be removed from the device when switching the viewpoint and moving to inside the mode (as shown in FIGs. 5A and 5B). Such implementations can improve the timeliness of rendering of 3D data, and also may improve the performance of the client application and its responsiveness to user interactions received through a device used by the user to interact with the data and navigate within the views of the 3D model.

The user interface 500 may be associated with a particular frame generation rate (e.g., is 71, 77, or 70, among other examples), where based on the current frame generation rate, an update to the model load limit can be determined as an auto-tune factor (e.g., auto-tune factor update of 29% for reducing the model load limit). By dynamically adjusting the model load limit, a selection of the objects that need to be loaded and those that need to be unloaded can be efficiently made to support scalability of the rendering at the device that allows for consistent performance during movement of the user within the environment and changing the viewpoint. The prioritized objects that are considered for the rendering are those that can fit into the model load limit (a limit threshold for polygons to be loaded) so that the system can afford to load and render them.

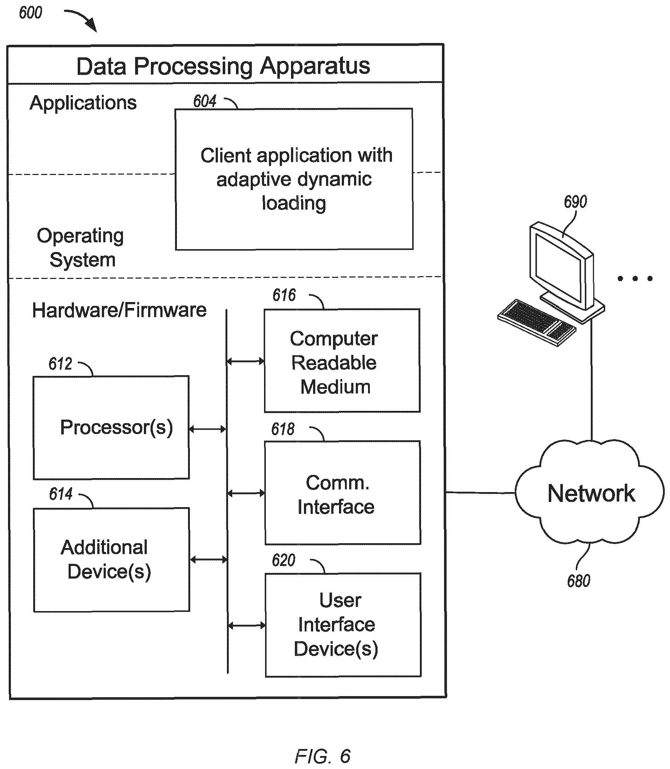

FIG. 6 is a schematic diagram of a data processing system including a data processing apparatus 600, which can be programmed as a client or as a server. The data processing apparatus 600 is connected with one or more computers 690 through a network 680. While only one computer is shown in FIG. 6 as the data processing apparatus 600, multiple computers can be used. The data processing apparatus 600 includes various software modules, which can be distributed between an applications layer and an operating system. These can include executable and/or interpretable software programs or libraries, including tools and services of a client application 604 that includes a user interface that allows displaying of a 3D model of environments to a user of the client application 604 in one or more review modes. Further, the client application 604 can implement an adaptive dynamic loading strategy to determine and load a portion of the objects of a 3D model that would facilitate efficient rendering that is sustainable for the client device without causing downtime due to loading overload.

The number of software modules used can vary from one implementation to another. Moreover, the software modules can be distributed on one or more data processing apparatus connected by one or more computer networks or other suitable communication networks.

The data processing apparatus 600 also includes hardware or firmware devices including one or more processors 612, one or more additional devices 614, a computer readable medium 616, a communication interface 618, and one or more user interface devices 620. Each processor 612 is capable of processing instructions for execution within the data processing apparatus 600. In some implementations, the processor 612 is a single or multi-threaded processor. Each processor 612 is capable of processing instructions stored on the computer readable medium 616 or on a storage device such as one of the additional devices 614. The data processing apparatus 600 uses the communication interface 618 to communicate with one or more computers 690, for example, over the network 680. Examples of user interface devices 620 include a display, a camera, a speaker, a microphone, a tactile feedback device, a keyboard, a mouse, and VR and/or AR equipment. The data processing apparatus 600 can store instructions that implement operations associated with the program(s) described above, for example, on the computer readable medium 616 or one or more additional devices 614, for example, one or more of a hard disk device, an optical disk device, a tape device, and a solid state memory device.

Embodiments of the subject matter and the functional operations described in this specification can be implemented in digital electronic circuitry, or in computer software, firmware, or hardware, including the structures disclosed in this specification and their structural equivalents, or in combinations of one or more of them. Embodiments of the subject matter described in this specification can be implemented using one or more modules of computer program instructions encoded on a non-transitory computer-readable medium for execution by, or to control the operation of, data processing apparatus. The computer-readable medium can be a manufactured product, such as a hard drive in a computer system or an optical disc sold through retail channels, or an embedded system. The computer-readable medium can be acquired separately and later encoded with the one or more modules of computer program instructions, e.g., after delivery of the one or more modules of computer program instructions over a wired or wireless network. The computer-readable medium can be a machine-readable storage device, a machine-readable storage substrate, a memory device, or a combination of one or more of them.

The term "data processing apparatus" encompasses all apparatus, devices, and machines for processing data, including by way of example a programmable processor, a computer, or multiple processors or computers. The apparatus can include, in addition to hardware, code that produces an execution environment for the computer program in question, e.g., code that constitutes processor firmware, a protocol stack, a database management system, an operating system, a runtime environment, or a combination of one or more of them. In addition, the apparatus can employ various different computing model infrastructures, such as web services, distributed computing, and grid computing infrastructures.

A computer program (also known as a program, software, software application, script, or code) can be written in any suitable form of programming language, including compiled or interpreted languages, declarative or procedural languages, and it can be deployed in any suitable form, including as a stand-alone program or as a module, component, subroutine, or other units suitable for use in a computing environment. A computer program does not necessarily correspond to a file in a file system. A program can be stored in a portion of a file that holds other programs or data (e.g., one or more scripts stored in a markup language document), in a single file dedicated to the program in question, or in multiple coordinated files (e.g., files that store one or more modules, sub-programs, or portions of code). A computer program can be deployed to be executed on one computer or on multiple computers that are located at one site or distributed across multiple sites and interconnected by a communication network.

The processes and logic flows described in this specification can be performed by one or more programmable processors, executing one or more computer programs to perform functions by operating on input data and generating output. The processes and logic flows can also be performed by, and apparatus can also be implemented as, special purpose logic circuitry, e.g., a field programmable gate array (FPGA) or an application-specific integrated circuit (ASIC).

Processors suitable for the execution of a computer program include, by way of example, both general and special purpose microprocessors, and any one or more processors of any kind of digital computer. Generally, a processor will receive instructions and data from a read-only memory or a random access memory, or both. The essential elements of a computer are a processor for performing instructions and one or more memory devices for storing instructions and data. Generally, a computer will also include, or be operatively coupled to receive data from or transfer data to, or both, one or more mass storage devices for storing data, e.g., magnetic, magneto-optical disks, or optical disks. However, a computer need not have such devices. Moreover, a computer can be embedded in another device, e.g., a mobile telephone, a personal digital assistant (PDA), a mobile audio or video player, a game console, a Global Positioning System (GPS) receiver, or a portable storage device (e.g., a universal serial bus (USB) flash drive), to name just a few. Devices suitable for storing computer program instructions and data include all forms of non-volatile memory, media, and memory devices, including by way of example semiconductor memory devices, e.g., EPROM (Erasable Programmable Read-Only Memory), EEPROM (Electrically Erasable Programmable Read-Only Memory), and flash memory devices; magnetic disks, e.g., internal hard disks or removable disks; magneto-optical disks; and CD-ROM and DVD-ROM disks. The processor and the memory can be supplemented by, or incorporated in, special purpose logic circuitry.

To provide for interaction with a user, embodiments of the subject matter described in this specification can be implemented on a computer having a display device, e.g., a liquid crystal display (LCD) device, an organic light emitting diode (OLED) display device, or another monitor, for displaying information to the user, and a keyboard and a pointing device, e.g., a mouse or a trackball, by which the user can provide input to the computer. Other kinds of devices can be used to provide for interaction with a user as well; for example, feedback provided to the user can be any suitable form of sensory feedback, e.g., visual feedback, auditory feedback, or tactile feedback; and input from the user can be received in any suitable form, including acoustic, speech, or tactile input.

The computing system can include clients and servers. A client and server are generally remote from each other, and typically interact through a communication network. The relationship of client and server arises by virtue of computer programs running on the respective computers and having a client-server relationship to each other. Embodiments of the subject matter described in this specification can be implemented in a computing system that includes a back-end component, e.g., as a data server, or that includes a middleware component, e.g., an application server, or that includes a front-end component, e.g., a client computer having a graphical user interface or a browser user interface, through which a user can interact with an implementation of the subject matter described in this specification, or any combination of one or more such back-end, middleware, or front-end components. The components of the system can be interconnected by any suitable form or medium of digital data communication, e.g., a communication network. Examples of communication networks include a local area network ("LAN") and a wide area network ("WAN"), an inter-network (e.g., the Internet), and peer-to-peer networks (e.g., ad hoc peer-to-peer networks).

While this specification contains many implementation details, these should not be construed as limitations on the scope of what is being or may be claimed, but rather as descriptions of features specific to particular embodiments of the disclosed subject matter. Certain features that are described in this specification in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the invention have been described. Other embodiments are within the scope of the following claims. In addition, actions recited in the claims can be performed in a different order and still achieve desirable results. The invention is defined by the appended claims.

## Claims

1. A computer-implemented method (200) comprising:
obtaining (210), by a computer having a display device and local memory, a three-dimensional spatial access tree data structure encoding location information for objects in a three-dimensional model of an environment, wherein the three-dimensional model is stored on a remote computer system;
ranking (220), by the computer, a set of the objects in the three-dimensional model to form an object hierarchy based at least on distances between each object of the set of objects and a specified viewpoint for a user within the environment, as determined using the three-dimensional spatial access tree data structure;
selecting (230), by the computer, a proper subset of the set of objects to be rendered based on the object hierarchy and a current model load limit;
downloading (240), by the computer and from the remote computer system, the proper subset of the set of objects to the local memory; and
rendering (250), by the computer, the proper subset of the set of objects from the local memory to the display device based on the specified viewpoint within the environment for the user.

2. The method of claim 1, wherein the three-dimensional spatial access tree data structure comprises a bounding volume hierarchy, and the obtaining comprises:
computing the bounding volume hierarchy including nodes corresponding to bounding volumes defined for respective spatial portions of the environment, wherein leaf nodes of the bounding volume hierarchy correspond to the objects in the three-dimensional model of the environment.

3. The method of claim 1 or claim 2, further comprising:
updating, by the computer, the current model load limit based on a current frame generation rate for the rendering; and
removing, by the computer, downloaded objects from the local memory based on the object hierarchy and in response to reaching the current model load limit within a threshold distance as a result of the downloading.

4. The method of claim 3, further comprising:
repeating, by the computer, the ranking, the selecting, the downloading, the rendering, the updating, and the removing, as changes to the specified viewpoint within the environment for the user are received.

5. The method of any one of the preceding claims, wherein obtaining the three-dimensional spatial access tree data structure comprises:
receiving the three-dimensional spatial access tree data structure for the environment in a communications stream from the remote computer system.

6. The method of any one of the preceding claims, wherein ranking the set of objects in the three-dimensional model comprises:
identifying the set of objects as including one or more objects from the objects in the three-dimensional model that are determined to be located within a zone of confidence around the specified viewpoint of the user based on matching a prioritization criterion for object loading,
wherein the set of objects are selected based on identifying the set of objects as the highest ranked objects from the objects as ranked that are to be loaded according to the current model load limit.

7. The method of claim 6, wherein the prioritization criterion for an object loading defines factors associated with prioritizing loading of a first object compared to loading of another object, wherein the factors comprise a comparative ratio between a size of an object and a size of the three-dimensional model, the specified viewpoint of the user, the distances between each object of the set of objects and the specified viewpoint for the user, a location of the user within the three-dimensional model, comparative position between each two of the objects within the environment from the specified viewpoint of the user, and physical properties of the object.

8. The method of claim 7, wherein the prioritization criterion is defined as a weighted combination of two or more of the defined factors, wherein each factor of the two or more defined factors is associated with a pre-defined weight for the weighted combination.

9. The method of any one of the preceding claims, comprising:
determining a change of the specified viewpoint of the user within the environment; and
repeating the ranking for a second set of objects in the environment, wherein the ranking is repeated for objects that at least partially overlap with the ranked set of objects that is a first set of objects that are ranked, wherein the ranking is performed to generate a new object hierarchy based on distances between objects in the second set of objects and a new viewpoint of the user determined based on the change in the location.

10. The method of claim 9, wherein at least one object of the second set of objects is downloaded as part of the proper subset of the set of objects to the local memory.

11. The method of any one of the preceding claims, wherein the three-dimensional spatial access tree data structure encodes metadata for the objects comprising object category and environmental properties defining location of the objects within the environment, and wherein the ranking of the set of objects comprises:
identifying the set of objects as including one or more objects from the objects in the three-dimensional model that are determined to match a prioritization criterion based on metadata of the objects.

12. A system comprising:
a non-transitory storage medium having instructions of a computer aided design program stored thereon; and
one or more data processing apparatus configured to run the instructions of the computer aided design program to perform operations according to the method of any one of claims 1 to 11.

13. A non-transitory computer-readable medium encoding instructions operable to cause data processing apparatus to perform operations according to the method of any one of claims 1 to 11

## Patentansprüche

1. Computer-implementiertes Verfahren (200), umfassend:
Erhalten (210) einer dreidimensionalen räumlichen Suchbaumdatenstruktur, die Standortinformationen für Objekte in einem dreidimensionalen Modell einer Umgebung codiert, durch einen Computer, aufweisend eine Anzeigevorrichtung und einen lokalen Speicher, wobei das dreidimensionale Modell auf einem entfernten Computersystem gespeichert ist;
Einstufen (220) eines Satzes der Objekte in dem dreidimensionalen Modell durch den Computer, um eine Objekthierarchie auszubilden, die mindestens auf Entfernungen zwischen jedem Objekt des Satzes von Objekten und einem spezifizierten Blickpunkt für einen Benutzer innerhalb der Umgebung basiert, wie sie unter Verwendung der dreidimensionalen räumlichen Suchbaumdatenstruktur bestimmt wird;
Auswählen (230) eines geeigneten Teilsatzes des Satzes von zu rendernden Objekten durch den Computer basierend auf der Objekthierarchie und einer aktuellen Modelllastgrenze;
Herunterladen (240) des geeigneten Teilsatzes des Satzes von Objekten durch den Computer und von dem entfernten Computersystem in den lokalen Speicher; und
Rendern (250) des geeigneten Teilsatzes des Satzes von Objekten von dem lokalen Speicher auf die Anzeigevorrichtung durch den Computer basierend auf dem spezifizierten Blickpunkt innerhalb der Umgebung für den Benutzer.

2. Verfahren nach Anspruch 1, wobei die dreidimensionale räumliche Suchbaumdatenstruktur eine Hüllkörperhierarchie umfasst und das Erhalten Folgendes umfasst:
Berechnen der Hüllkörperhierarchie, einschließlich Knoten, die Hüllkörpern entsprechen, die für jeweilige räumliche Abschnitte der Umgebung definiert sind, wobei Blattknoten der Hüllkörperhierarchie den Objekten in dem dreidimensionalen Modell der Umgebung entsprechen.

3. Verfahren nach Anspruch 1 oder Anspruch 2, ferner umfassend:
Aktualisieren der aktuellen Modelllastgrenze durch den Computer basierend auf einer aktuellen Bilderzeugungsrate für das Rendern; und
Entfernen heruntergeladener Objekte aus dem lokalen Speicher durch den Computer basierend auf der Objekthierarchie und als Reaktion auf ein Erreichen der aktuellen Modelllastgrenze innerhalb einer Schwellenwertentfernung als ein Ergebnis des Herunterladens.

4. Verfahren nach Anspruch 3, ferner umfassend:
Wiederholen des Einstufens, des Auswählens, des Herunterladens, des Renderns, des Aktualisierens und des Entfernens durch den Computer, wenn Änderungen an dem spezifizierten Blickpunkt innerhalb der Umgebung für den Benutzer empfangen werden.

5. Verfahren nach einem der vorhergehenden Ansprüche, wobei das Erhalten der dreidimensionalen räumlichen Suchbaumdatenstruktur Folgendes umfasst:
Empfangen der dreidimensionalen räumlichen Suchbaumdatenstruktur für die Umgebung in einem Kommunikationsstrom von dem entfernten Computersystem.

6. Verfahren nach einem der vorhergehenden Ansprüche, wobei das Einstufen des Satzes von Objekten in dem dreidimensionalen Modell Folgendes umfasst:
Identifizieren des Satzes von Objekten als einschließlich eines oder mehrerer Objekte von den Objekten in dem dreidimensionalen Modell, die basierend auf einem Erfüllen eines Priorisierungskriteriums für ein Laden von Objekten bestimmt sind, sich innerhalb einer Vertrauenszone um den spezifizierten Blickpunkt des Benutzers zu befinden,
wobei der Satz von Objekten basierend auf dem Identifizieren des Satzes von Objekten als die am höchsten eingestuften Objekte von den gemäß der aktuellen Modelllastgrenze zu ladenden eingestuften Objekten ausgewählt ist.

7. Verfahren nach Anspruch 6, wobei das Priorisierungskriterium für ein Laden von Objekten Faktoren definiert, die mit einem Priorisieren eines Ladens eines ersten Objekts verglichen mit einem Laden eines anderen Objekts verknüpft sind, wobei die Faktoren ein vergleichendes Verhältnis zwischen einer Größe eines Objekts und einer Größe des dreidimensionalen Modells, den spezifizierten Blickpunkt des Benutzers, die Entfernungen zwischen jedem Objekt des Satzes von Objekten und den spezifizierten Blickpunkt für den Benutzer, einen Standort des Benutzers innerhalb des dreidimensionalen Modells, eine vergleichende Position zwischen jeweils zwei der Objekte innerhalb der Umgebung von dem spezifizierten Blickpunkt des Benutzers und physikalische Eigenschaften des Objekts umfassen.

8. Verfahren nach Anspruch 7, wobei das Priorisierungskriterium als eine gewichtete Kombination von zwei oder mehr der definierten Faktoren definiert ist, wobei jeder Faktor der zwei oder mehr definierten Faktoren mit einem vordefinierten Gewicht für die gewichtete Kombination verknüpft ist.

9. Verfahren nach einem der vorhergehenden Ansprüche, umfassend:
Bestimmen einer Änderung des spezifizierten Blickpunkts des Benutzers innerhalb der Umgebung; und
Wiederholen des Einstufens für einen zweiten Satz von Objekten in der Umgebung, wobei das Einstufen für Objekte wiederholt wird, die sich mindestens teilweise mit dem eingestuften Satz von Objekten überschneiden, der ein erster Satz von Objekten ist, die eingestuft sind, wobei das Einstufen durchgeführt wird, um eine neue Objekthierarchie basierend auf Entfernungen zwischen Objekten in dem zweiten Satz von Objekten und einem neuen Blickpunkt des Benutzers, der basierend auf der Änderung an dem Standort bestimmt wird, zu erzeugen.

10. Verfahren nach Anspruch 9, wobei mindestens ein Objekt des zweiten Satzes von Objekten als Teil des geeigneten Teilsatzes des Satzes von Objekten in den lokalen Speicher heruntergeladen wird.

11. Verfahren nach einem der vorhergehenden Ansprüche, wobei die dreidimensionale räumliche Suchbaumdatenstruktur Metadaten für die Objekte codiert, umfassend eine Objektkategorie und Umgebungseigenschaften, die einen Standort der Objekte innerhalb der Umgebung definieren, und wobei das Einstufen des Satzes von Objekten Folgendes umfasst:
Identifizieren des Satzes von Objekten als einschließlich eines oder mehrerer Objekte von den Objekten in dem dreidimensionalen Modell, die basierend auf Metadaten der Objekte bestimmt sind, ein Priorisierungskriterium zu erfüllen.

12. System, umfassend:
ein nicht-transitorisches Speichermedium, aufweisend darauf gespeicherte Anweisungen eines computergestützten Designprogramms; und
eine oder mehrere Datenverarbeitungsvorrichtungen, die konfiguriert sind, um die Anweisungen des computergestützten Designprogramms auszuführen, um Vorgänge gemäß dem Verfahren nach einem der Ansprüche 1 bis 11 durchzuführen.

13. Nicht-transitorisches, computerlesbares Medium, das Anweisungen codiert, die betreibbar sind, um eine Datenverarbeitungsvorrichtung dazu zu veranlassen, Vorgänge gemäß dem Verfahren nach einem der Ansprüche 1 bis 11 durchzuführen.

## Revendications

1. Procédé mis en œuvre par ordinateur (200) comprenant :
l'obtention (210), par un ordinateur ayant un dispositif d'affichage et une mémoire locale, d'une structure de données d'arbre d'accès spatial tridimensionnel codant des informations d'emplacement pour des objets dans un modèle tridimensionnel d'un environnement, dans lequel le modèle tridimensionnel est stocké sur un système informatique distant ;
le classement (220), par l'ordinateur, d'un ensemble des objets dans le modèle tridimensionnel pour former une hiérarchie d'objets sur la base au moins de distances entre chaque objet de l'ensemble d'objets et un point de vue spécifié pour un utilisateur dans l'environnement, tel que déterminé à l'aide de la structure de données d'arbre d'accès spatial tridimensionnel ;
la sélection (230), par l'ordinateur, d'un sous-ensemble approprié de l'ensemble d'objets à restituer sur la base de la hiérarchie d'objets et d'une limite de charge de modèle actuelle ;
le téléchargement (240), par l'ordinateur et à partir du système informatique distant, du sous-ensemble approprié de l'ensemble d'objets vers la mémoire locale ; et
la restitution (250), par l'ordinateur, du sous-ensemble approprié de l'ensemble d'objets depuis la mémoire locale vers le dispositif d'affichage sur la base du point de vue spécifié dans l'environnement pour l'utilisateur.

2. Procédé selon la revendication 1, dans lequel la structure de données d'arbre d'accès spatial tridimensionnel comprend une hiérarchie de volumes englobants, et l'obtention comprend :
le calcul de la hiérarchie de volumes englobants comportant des nœuds correspondant aux volumes englobants définis pour les portions spatiales respectives de l'environnement, dans lequel les nœuds feuilles de la hiérarchie de volumes englobants correspondent aux objets dans le modèle tridimensionnel de l'environnement.

3. Procédé selon la revendication 1 ou la revendication 2, comprenant également :
la mise à jour, par l'ordinateur, de la limite de charge de modèle actuelle sur la base d'un taux de génération d'images actuel pour la restitution ; et
la suppression, par l'ordinateur, d'objets téléchargés de la mémoire locale sur la base de la hiérarchie d'objets et en réponse à l'atteinte de la limite de charge de modèle actuelle à une distance seuil à la suite du téléchargement.

4. Procédé selon la revendication 3, comprenant également :
la répétition, par l'ordinateur, des opérations de classement, de sélection, de téléchargement, de restitution, de mise à jour et de suppression, à mesure que sont reçues des modifications du point de vue spécifié dans l'environnement pour l'utilisateur.

5. Procédé selon l'une quelconque des revendications précédentes, dans lequel l'obtention de la structure de données d'arbre d'accès spatial tridimensionnel comprend :
la réception de la structure de données d'arbre d'accès spatial tridimensionnel pour l'environnement dans un flux de communication en provenance du système informatique distant.

6. Procédé selon l'une quelconque des revendications précédentes, dans lequel le classement de l'ensemble d'objets dans le modèle tridimensionnel comprend :
l'identification de l'ensemble d'objets comme comportant un ou plusieurs objets à partir des objets dans le modèle tridimensionnel qui sont déterminés comme étant situés dans une zone de confiance autour du point de vue spécifié de l'utilisateur sur la base de la concordance avec un critère de priorisation pour le chargement d'objet,
dans lequel l'ensemble d'objets sont sélectionnés sur la base de l'identification de l'ensemble d'objets comme étant les objets les mieux classés parmi les objets classés qui doivent être chargés selon la limite de charge de modèle actuelle.

7. Procédé selon la revendication 6, dans lequel le critère de priorisation pour un chargement d'objet définit des facteurs associés à la priorisation du chargement d'un premier objet par rapport au chargement d'un autre objet, dans lequel les facteurs comprennent un rapport comparatif entre une taille d'un objet et une taille du modèle tridimensionnel, le point de vue spécifié de l'utilisateur, les distances entre chaque objet de l'ensemble d'objets et le point de vue spécifié pour l'utilisateur, un emplacement de l'utilisateur dans le modèle tridimensionnel, la position comparative entre chaque paire d'objets dans l'environnement à partir du point de vue spécifié de l'utilisateur et les propriétés physiques de l'objet.

8. Procédé selon la revendication 7, dans lequel le critère de priorisation est défini comme une combinaison pondérée de deux des facteurs définis ou plus, dans lequel chaque facteur des deux facteurs définis ou plus est associé à un poids prédéfini pour la combinaison pondérée.

9. Procédé selon l'une quelconque des revendications précédentes, comprenant :
la détermination d'une modification du point de vue spécifié de l'utilisateur dans l'environnement ; et
la répétition du classement pour un second ensemble d'objets dans l'environnement, dans lequel le classement est répété pour les objets qui chevauchent au moins partiellement l'ensemble d'objets classés, qui est un premier ensemble d'objets qui sont classés, dans lequel le classement est réalisé pour générer une nouvelle hiérarchie d'objets sur la base de distances entre les objets dans le second ensemble d'objets et un nouveau point de vue de l'utilisateur déterminé sur la base de la modification de l'emplacement.

10. Procédé selon la revendication 9, dans lequel au moins un objet du second ensemble d'objets est téléchargé en tant que partie du sous-ensemble approprié de l'ensemble d'objets vers la mémoire locale.

11. Procédé selon l'une quelconque des revendications précédentes, dans lequel la structure de données d'arbre d'accès spatial tridimensionnel code des métadonnées pour les objets comprenant une catégorie d'objet et des propriétés environnementales définissant l'emplacement des objets dans l'environnement, et dans lequel le classement de l'ensemble d'objets comprend :
l'identification de l'ensemble d'objets comme comportant un ou plusieurs objets à partir des objets dans le modèle tridimensionnel qui sont déterminés comme concordant avec un critère de priorisation sur la base des métadonnées des objets.

12. Système comprenant :
un support de stockage non transitoire sur lequel sont stockées les instructions d'un programme de conception assistée par ordinateur ; et
un ou plusieurs appareils de traitement de données configurés pour exécuter les instructions du programme de conception assistée par ordinateur pour réaliser des opérations selon le procédé selon l'une quelconque des revendications 1 à 11.

13. Support non transitoire lisible par ordinateur codant des instructions opérationnelles pour amener un appareil de traitement de données à réaliser des opérations selon le procédé selon l'une quelconque des revendications 1 à 11.
